Europäisches Patentamt

**European Patent Office**

Office européen des brevets

(11) Veröffentlichungsnummer: **0 090 058**
**B1**

(12) **EUROPÄISCHE PATENTSCHRIFT**

(45) Veröffentlichungstag der Patentschrift:
**04.06.86**

(21) Anmeldenummer: **82102519.4**

(22) Anmeldetag: **25.03.82**

(51) Int. Cl.⁴: **B 41 J 3/20,** G 01 D 15/08 //
**H03K17/04**

(54) Transistorschaltung zum Schalten des Schreibstromes bei einem Metallpapierdrucker und zum selbsttätigen Verringern des Schreibstromes nach dem Zünden des Lichtbogens.

(43) Veröffentlichungstag der Anmeldung:
**05.10.83 Patentblatt 83/40**

(45) Bekanntmachung des Hinweises auf die Patenterteilung:
**04.06.86 Patentblatt 86/23**

(84) Benannte Vertragsstaaten:
**DE FR GB IT**

(56) Entgegenhaltungen:
**DE - A - 1 548 595**
**DE - A - 2 423 258**
**DE - B - 2 916 105**
**FR - A - 2 319 433**
**US - A - 3 396 314**
**US - A - 3 631 509**

**ELEKTROTECHNIK, Band 63, Nr. 17, September 1981, Seite 66, Würzburg, DE. "Treiber für Magnete und Schütze"**
**ELEKTROTECHNIK, Band 61, Nr. 20, Oktober 1979, Seiten 24-26 und 28, Würzburg, DE. "Einfach und betriebssicher"**

(73) Patentinhaber: **IBM DEUTSCHLAND GMBH, Pascalstrasse 100, D-7000 Stuttgart 80 (DE)**

(84) Benannte Vertragsstaaten: **DE**

(73) Patentinhaber: **International Business Machines Corporation, Old Orchard Road, Armonk, N.Y. 10504 (US)**

(84) Benannte Vertragsstaaten: **FR GB IT**

(72) Erfinder: **Goldrian, Gottfried, Gutacher Weg 18, D-7030 Böblingen (DE)**
Erfinder: **Rudolph, Volker, Dr. Phys., Finkenweg 20, D-7031 Aidlingen 3 (DE)**

(74) Vertreter: **Neuland, Johannes, Dipl.-Ing., Schönaicher Strasse 220, D-7030 Böblingen (DE)**

## Beschreibung

Die Erfindung bezieht sich auf eine Transistorschaltung zum Schalten des Schreibstromes bei einem Metallpapierdrucker und zum selbsttätigen Verringern des Schreibstromes nach dem Zünden des Lichtbogens (DE-A-1 548 595).

Bei Metallpapierdruckern erfolgt die Informationsaufzeichnung bekanntlich dadurch, dass zwischen einer Schreibelektrode, die auf einer dünnen Metallschicht des Aufzeichnungsträgers aufliegt, und dieser Metallschicht ein Lichtbogen gezündet wird. Dieser bewirkt ein Ausbrennen der Metallschicht an der Stelle der Schreibelektrode. Für das Zünden des Lichtbogens ist zunächst ein rasch ansteigender Strom erforderlich, der jedoch nach dem Zündvorgang möglichst schnell auf einen Bruchteil des zum Zünden erforderlichen Wertes verringert werden muss. Andernfalls erfolgt ein zu grosser Ausbrand der Metallschicht, was zu einer schlechten Druckqualität führt.

In der EP-A-00 48 295 sind ein Verfahren und Anordnungen zum Steuern des Schreibstromes bei Metallpapierdruckern beschrieben. Dabei wird zum Verringern des Schreibstromes der beim Zünden des Lichtbogens an der Schreibelektrode auftretende Potentialsprung abgefühlt und zum Verringern des Schreibstromes herangezogen. Dazu beeinflusst der Potentialsprung über mehrere Halbleiter-Schaltungselemente den Steuereingang eines als Darlington-Schaltung ausgeführten Emitterfolgers, über den der Schreibstrom fliesst. Ausser den durch die Halbleiter-Schaltungselemente, über die der Steuereingang des Emitterfolgers beeinflusst wird, bedingten Verzögerungen beim Verringern des Schreibstromes ist bei der älteren Schaltung am Eingang des Emitterfolgers eine Kapazität zur Unterdrückung der Schwingneigung der Schaltung erforderlich. Sie bildet mit dem Kollektorwiderstand einer den Steuerstrom für den Emitterfolger liefernden Transistorstufe ein RC-Glied. Das hat zur Folge, dass der Schreibstrom nach dem Zünden des Lichtbogens erst dann auf einen Bruchteil seines ursprünglichen Wertes zurückgehen kann, wenn sich das RC-Glied auf eine geringere Steuerspannung entladen hat. Hierdurch ist eine zusätzliche Verzögerung für das Verringern des Schreibstromes gegeben. Bei der bekannten Anordnung erfolgt daher das Aufzeichnen mit einer grösseren als der minimalen elektrischen Energie, was sich nachteilig auf die Druckqualität auswirkt.

Hier will die Erfindung Abhilfe schaffen. Die Erfindung, wie sie im Anspruch 1 gekennzeichnet ist, löst die Aufgabe, eine Transistorschaltung zum selbsttätigen Verringern des Schreibstromes bei Metallpapierdruckern nach dem Zünden des Lichtbogens anzugeben, die es ermöglicht, nur mit der für das Drucken erforderlichen minimalen elektrischen Energie zu arbeiten.

Der durch die Erfindung erreichte Vorteil besteht in einer deutlich verbesserten Druckqualität.

Im folgenden wird die Erfindung in Verbindung mit den Zeichnungen näher erläutert. Von den Zeichnungen zeigen:

Fig. 1 das Prinzipschaltbild einer Transistorschaltung gemäss der Erfindung;

Fig. 2 den zeitlichen Verlauf des über die Schreibelektrode fliessenden Stromes innerhalb der maximal für das Drucken zur Verfügung stehenden Zeitspanne T.

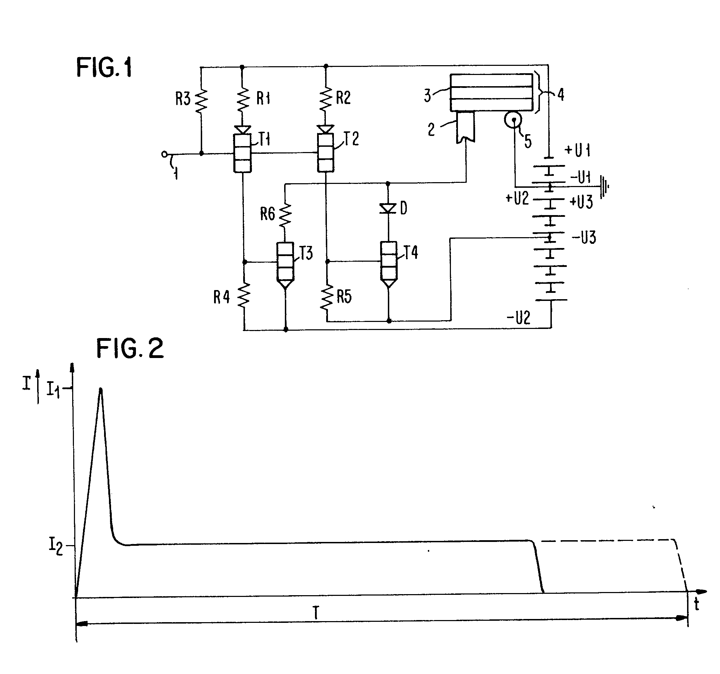

Die Schaltung nach Fig. 1 enthält die beiden den Schreibstrom schaltenden NPN-Leistungstransistoren T3 und T4 sowie zwei Konstantstromquellen, die unter Verwendung der beiden PNP-Transistoren T1 und T2 aufgebaut sind und die Basisströme für die Transistoren T3 und T4 liefern. Die Basiselektroden der Transistoren T1 und T2 sind miteinander und mit dem Eingang 1 der Schaltung verbunden. Über den Widerstand R3 sind sie an den Pluspol einer ersten Betriebsspannungsquelle U1 von z.B. 5 V angeschlossen, deren Minuspol an Masse liegt. Über die die Grösse der Kontantströme bestimmenden Widerstände R1 und R2 sind die Emitter der Transistoren T1 und T2 ebenfalls mit dem Pluspol der ersten Betriebsspannungsquelle U1 verbunden, während der Kollektor des Transistors T1 an die Basis des Transistors T3 und der Kollektor des Transistors T2 an die Basis des Transistors T4 angeschlossen ist. Über den Widerstand R4 ist die Basis des Transistors T3 mit dem Minuspol einer zweiten Betriebsspannungsquelle U2 von z.B. 48 V verbunden, an den auch sein Emitter angeschlossen ist. Über den Widerstand R6 ist der Kollektor dieses Transistors mit der Schreibelektrode 2 verbunden, die auf der Metallschicht 3 des Aufzeichnungsträgers 4 aufliegt. Über eine Kontaktrolle 5 ist die Metallschicht 3 des Aufzeichnungsträgers 4 an den Pluspol der zweiten Betriebsspannungsquelle, der an Masse liegt, angeschlossen. Der Kollektor des Transistors T4 ist über die in Durchlassrichtung gepolte Diode D mit der Schreibelektrode 2 verbunden. Über den Widerstand R5 ist die Basis des Transistors T4 an den Minuspol einer dritten Betriebsspannungsquelle U3 von z.B. 18 V angeschlossen. Diese dritte Betriebsspannungsquelle wird durch einen Abgriff an der zweiten Betriebsspannungsquelle, mit der sie den Pluspol gemeinsam hat, gewonnen. An ihrem Minuspol ist auch der Emitter des Transistors T4 angeschlossen.

Die Wirkungsweise der Schaltung nach Fig. 1 ist folgende:

Im ausgeschalteten Zustand liegt am Eingang 1 der Schaltung eine positive Spannung von z.B. 5 V. Sie sorgt dafür, dass kein Basisstrom über den Widerstand R3 fliessen kann, da dessen beide Anschlussenden sich auf gleichem Potential befinden. Die Transistoren T1 und T2 sind daher nichtleitend und damit auch die Transistoren T3 und T4. Wenn gedruckt werden soll, muss der Schreibstromkreis, der von den an das Bezugspotential angeschlossenen Pluspolen der beiden Betriebsstromquellen U2 und U3, der Kontaktrolle 5, der Metallschicht 3 des Aufzeichnungsträgers 4, der darauf aufliegenden Schreibelektrode 2, den beiden damit verbundenen Transistoren T3 und T4 sowie den Minuspolen der beiden Betriebsspannungsquellen gebildet wird, geschlossen werden. Dazu wird das Potential des Eingangs 1 für eine Zeitspanne T, die der maximalen Dauer des Schreib- bzw. Druckvorganges entspricht, abgesenkt. Dadurch werden die beiden Transistoren T1 und T2 leitend und daher auch die beiden Transistoren T3 und T4. Damit ist der Schreibstromkreis geschlossen. Es fliesst jetzt der Schreibstrom, der sich aus die den Transistoren T3 und T4 durchfliessenden Teilströmen zusammensetzt. Da im Stromkreis des Transistors T4 keine Ohm'schen Widerstände angeordnet sind, steigt der ihn durchfliessende Teilstrom sehr schnell an. Infolge der hohen Stromdichte, die an der Kontaktstelle von Schreibelektrode 2 und Metallschicht 3 des Aufzeichnungsträgers 4 herrscht, schmilzt und verdampft dort die oberste Lage der Metallschicht. Daraufhin bildet sich zwischen der Schreibelektrode 2 und der Metallschicht 3 zur Aufrechterhaltung des Stromflusses ein Lichtbogen aus, der die Metallschicht an der Stelle der Schreibelektrode ausbrennt. Um ein unerwünscht grosses Ausbrennen zu vermeiden, muss nach dem Zünden des Lichtbogens der Schreibstrom rasch auf einen Bruchteil des zum Zünden erforderlichen Wertes verringert werden. Dies wird bei der Schaltung nach der Erfindung dadurch erreicht, dass der Leistungtransistor T4 mit einer Betriebsspannung arbeitet, deren Grösse dem Potentialsprung entspricht, der zum Aufrechterhalten des Lichtbogens an der Schreibelektrode 2 auftritt. Dadurch ist nach dem Zünden des Lichtbogens die Differenz zwischen dem Emitterpotential des Transistors T4 und dem Anodenpotential der mit ihm in Reihe liegenden Diode D nicht mehr positiv, sondern 0 bzw. negativ. Eine positive Potentialdifferenz ist jedoch eine Voraussetzung für das Leiten dieses Transistors. Der von ihm vor dem Zünden des Lichtbogens gelieferte grosse Teilstrom entfällt daher jetzt. Der für den weiteren Schreibvorgang erforderliche verringerte Schreibstrom wird nun nur von dem Transistor T3 geliefert, der aufgrund seines hohen negativen Emitterpotentials von −48 V auch nach dem Potentialsprung an der Schreibelektrode leitend bleibt. Die Grösse des jetzt fliessenden Schreibstromes, der dem Lichtbogenstrom entspricht, wird durch den Widerstand R6 begrenzt. Dieser Strom fliesst bis zum Abreissen des Lichtbogens nach dem völligen Ausbrennen der Metallschicht 3 oder bis zum Ende des Zeitintervalls T, an dem das Potential des Schaltungseingangs 1 wieder erhöht wird, wodurch dann die Transistoren T1 bis T4 nichtleitend werden. Nach dem Zünden des Lichtbogens verhindert die Diode D den Inversbetrieb des Transistors T4, der sonst bei weiterem Absinken des Potentials der Schreibelektrode im Verlaufe des Ausbrennens der Metallschicht auftreten könnte. Der dem Transistor T4 auch in nichtleitendem Zustand von dem Transistor T2 zugeführte Basisstrom fliesst nur bei vorhandener Diode D über die Basisemitterdiode des Transistors T4 zum Minuspol der Betriebsspannungsquelle U3. Anstelle des Transistors T4 kann auch eine Darlington-Schaltung verwendet werden. Ferner kann, um ein schnelles Sperren des Transistors T3 am Ende des Zeitintervalls T zu erreichen, ein Sättigungsbetrieb dieses Transistors durch eine Diode verhindert werden, die zwischen seiner Basis- und seiner Kollektorelektrode angeordnet ist.

In Fig. 2 ist der zeitliche Verlauf des Schreibstromes qualitativ wiedergegeben. Dem Diagramm ist zu entnehmen, dass zu Beginn des Schreibintervalles T der Schreibstrom, der sich aus den die Transistoren T3 und T4 durchfliessenden Teilströmen zusammensetzt, sehr schnell auf einen Wert I1 ansteigt, bei dem sich ein Lichtbogen ausbildet. Je nach der Dicke der Metallschicht ist dieser Stromwert I1 grösser oder geringer. Nach dem Zünden des Lichtbogens fällt der Schreibstrom von dem Wert I1 dann äusserst rasch auf den zum Aufrechterhalten des Lichtbogens erforderlichen verringerten Wert I2 ab. Das äusserst schnelle Verringern des Schreibstromes auf einen Bruchteil seines Maximalwertes wird durch die sehr kurze Zeit ermöglicht, die nur erforderlich ist, um die Diode D vom leitenden in den gesperrten Zustand zu bringen. Der Lichtbogen reisst dann entweder nach dem völligen Ausbrennen der Metallschicht 3 an einer Stelle innerhalb des Zeitintervalls T ab, wodurch kein Schreibstrom mehr fliesst, oder das Weiterfliessen des Schreibstromes wird am Ende des für das Schreiben maximal vorgesehenen Zeitintervalls T durch einen Potentialanstieg am Eingang 1 der Schaltung, durch den sämtliche Transistoren nichtleitend werden, unterbunden.

### Patentansprüche

1. Transistorschaltung zum Schalten des Schreibstromes bei einem Metallpapierdrucker und zum selbsttätigen Verringern des Schreibstromes nach dem Zünden des Lichtbogens, dadurch gekennzeichnet, dass zwei Transistor-Leistungsstufen (T3, T4) an die Schreibelektrode (2) und an Betriebsspannungsquellen (U2, U3) unterschiedlicher Spannungshöhe derart angeschlossen sind, dass die zweite Transistor-Leistungsstufe (T4) infolge des beim Zünden des Lichtbogens zwischen der Metallschicht (3) des Aufzeichnungsträgers (4) und der Schreibelektrode (2) an dieser auftretenden Potentialsprungs keinen Beitrag zum Schreibstrom mehr leistet und dass die Kollektor-Elektrode dieser Transistor-Leistungsstufe (T4) über eine Diode (D), die nach dem Zünden des Lichtbogens den Inversbetrieb der Transistor-Leistungsstufe verhindert, an die Schreibelektrode angeschlossen ist.

2. Transistorschaltung nach Anspruch 1, dadurch gekennzeichnet, dass die Transistor-Leistungsstufen (T3, T4) über Konstantstromquellen (T1, T2) geschaltet werden.

3. Transistorschaltung nach Anspruch 2, dadurch gekennzeichnet, dass die Konstantstromquellen (T1, T2) vom entgegengesetzten Leitfähigkeitstyp wie die Transistor-Leistungsstufen (T3, T4) sind.

4. Transistorschaltung nach Anspruch 1, dadurch gekennzeichnet, dass die zweite Transistor-Leistungsstufe (T4) als Darlington-Schaltung ausgeführt ist.

5. Transistorschaltung nach mindestens einem der Ansprüche 1 bis 4, dadurch gekennzeichnet, dass die Betriebsspannungsquelle (+U3, −U3) für die zweite Transistor-Leistungsstufe (T4) durch einen Abgriff aus der Betriebsspannungsquelle (+U2, −U2) für die erste Leistungsstufe (T3), mit der sie den zweiten Pol gemeinsam hat, gebildet wird.

6. Transistorschaltung nach mindestens einem der Ansprüche 1 bis 5, dadurch gekennzeichnet, dass bei der ersten Transistor-Leistungsstufe (T3) zur Verhinderung des Sättigungsbetriebes eine Diode zwischen Basis und Kollektor vorgesehen ist.

**Revendications**

1. Circuit à transistors pour la commutation du courant d'impression dans une imprimante pour papier métallisé et pour la réduction automatique de ce courant après l'amorçage de l'arc électrique, caractérisé en ce que deux étages de puissance à transistors (T3, T4) sont raccordés à l'électrode d'impression (2) et à des sources de tensions d'alimentation (U2, U3) possédant des amplitudes de tension différentes de telle sorte que le second étage de puissance à transistor (T4) n'apporte plus aucune contribution au courant d'impression après le saut de potentiel apparaissant au niveau de l'électrode d'enregistrement (2) lors de l'amorçage de l'arc électrique entre la couche métallisée (3) du support d'enregistrement (4) et l'électrode d'enregistrement (2), et que l'électrode de collecteur de cet étage de puissance à transistor (T4) est raccordée à l'électrode d'impression par l'intermédiaire d'une diode (D), qui empêche, après l'amorçage de l'arc électrique, le fonctionnement inverse de l'étage de puissance à transistor.

2. Circuit à transistors selon la revendication 1, caractérisé en ce que les étages de puissance à transistors (T3, T4) sont commandés par des sources de courants constants (T1, T2).

3. Circuit à transistors suivant la revendication 2, caractérisé par le fait que les sources de courants constants (T1, T2) sont d'un type de conductivité opposé de celui des étages de puissance à transistors (T3, T4).

4. Circuit à transistors suivant la revendication 1, caractérisé par le fait que le second étage de puissance à transistor (T4) est réalisé sous la forme d'un montage Darlington.

5. Circuit à transistors selon au moins l'une des revendications 1 à 4, caractérisé en ce que la source de tension d'alimentation (+U3, −U3) pour le second étage de puissance à transistor (T4) est formée par une prise de sortie de la source de tension d'alimentation (+U2, −U2) prévue pour le première étage de puissance (T3), avec laquelle elle a le second pôle en commun.

6. Circuit à transistors selon au moins l'une des revendications 1 à 5, caractérisé en ce que dans le cas du premier étage de puissance à transistor (T3), une diode est prévue entre la base et le collecteur afin d'empêcher le fonctionnement à la saturation.

**Claims**

1. Transistor circuit for switching the print current in a metal paper printer and for automatically reducing the print current after ignition of the arc, characterized in that two transistor power stages (T3, T4) are connected to the print electrode (2) and to operating voltage sources (U2, U3) of different magnitude such that the second transistor power stage (T4), as a result of the drop in potential occurring at it upon ignition of the arc between the metal layer (3) of the record carrier (4) and the print electrode (2), no longer contributes to the print current, and that the collector electrode of said transistor power stage (T4) is connected to the print electrode through a diode (D) which after ignition of the arc prevents said transistor power stage from being inversely operated.

2. Transistor circuit according to claim 1, characterized in that the transistor power stages (T3, T4) are switched by constant current sources (T1, T2).

3. Transistor circuit according to claim 2, characterized in that the conductivity type of the constant current sources (T1, T2) is opposite to that of the transistor power stages (T3, T4).

4. Transistor circuit according to claim 1, characterized in that the second transistor power stage (T4) is a Darlington circuit.

5. Transistor circuit according to at least one of the claims 1 to 4, characterized in that the operating voltage source (+U3, −U3) for the second transistor power stage (T4) is derived by tapping the operating voltage source (+U2, −U2) for the first power stage (T3) with which it has the second pole in common.

6. Transistor circuit according to at least one of the claims 1 to 5, characterized in that the first transistor power stage (T3) is prevented from being driven into saturation by a diode arranged between its base and collector.

1/1

**FIG.1**

**FIG.2**